# DEMANDE DE BREVET EUROPEEN

(11) **EP 4 525 587 A1**
(43) Date de publication de la demande: **19.03.2025**
(21) Numéro de dépôt: 24198188.5
(22) Date de dépôt: 03.09.2024
(51) Int. Cl.: H10F 39/18

(54) **RÉSEAU IMAGEUR À PHOTODIODES CONVEXES**

(30) Priorité: 14.09.2023 FR 2309705
(71) Demandeur: Commissariat à l'Energie Atomique et aux Energies Alternatives, 75015 Paris (FR)
(72) Inventeur: ROTHMAN, Johan, 38054 GRENOBLE CEDEX 09 (FR)
(74) Mandataire: Hautier IP

(57) **Abrégé**

L'invention concerne un réseau (1) d'au moins deux photodiodes (100a, 100b) dans lequel chaque photodiode comprend une région d'absorption (20) et une région de captation (70), la région de captation (70) comprenant un plot (50) électriquement conducteur, la région d'absorption (20) étant en contact avec la région de captation (70), la région d'absorption (20) étant configurée pour absorber un rayonnement incident sur la photodiode et pour permettre une diffusion de porteurs de charge, dans lequel chaque région d'absorption (20) est séparée des autres régions d'absorption (20), et dans lequel la région d'absorption (20) de chaque photodiode (100a, 100b) présente une forme convexe vers le rayonnement incident.

## Description

### DOMAINE TECHNIQUE

La présente invention concerne la réalisation d'un réseau de photodiodes agencées sur un substrat semi-conducteur. Elle trouve par exemple pour application particulièrement avantageuse le domaine d'imagerie, notamment l'imagerie infrarouge à faible pas de pixel et à haute température de fonctionnement.

### ETAT DE LA TECHNIQUE

Les réseaux conventionnels de photodiodes présentent une architecture dite planaire, dans laquelle les photodiodes du réseau sont agencées d'une manière périodique sur une surface plane. Cette architecture planaire a l'avantage d'une fabrication relativement simple. En contrepartie, elle présente des limitations en termes de performances à cause de la diffusion des porteurs de charges photo-générés dans la région d'absorption du rayonnement au sein de chaque photodiode vers les photodiodes voisines. Cette contamination de porteurs de charge connue sous le terme diaphonie, ou « crosstalk » en anglais, engendre la détérioration des performances d'un réseau à haute densité de photodiodes en réduisant la fonction de transfert de modulation (FTM).

Afin de réduire la diaphonie, il est possible de réduire l'épaisseur de la couche d'absorption. Cependant, cette solution a tendance à réduire le rendement quantique du réseau.

Une autre solution consiste à fabriquer un réseau de photodiodes à jonction p-n verticale par rapport au substrat. Le contact entre les photodiodes et un circuit intégré de lecture (« Readout integrated circuit » ou ROIC en anglais) est établi en gravant une ouverture entre les photodiodes à travers les multi-couches arrivant jusqu'au plots électriques. La réalisation d'un tel réseau à haute densité de photodiodes sur des multi-couches épaisses parait difficile et susceptible d'engendrer une perte de rendement quantique du réseau, due au grand volume occupé par les ouvertures gravées entre les photodiodes.

Une autre solution préexistante est de fabriquer des photodiodes en forme de mesa, en gravant des tranchées suffisamment profondes entre les photodiodes afin de les séparer physiquement. Cette solution permet de confiner les porteurs de charges dans chaque pixel, et de surmonter le problème de la diaphonie. En revanche, la présence des tranchées peut fortement réduire le rendement quantique et augmenter les courants de fuite. De plus, la FTM peut également être réduite par la diffusion du rayonnement incident sur les flancs des tranchées vers les photodiodes voisines.

Dans le but de concentrer le rayonnement incident au centre de chaque pixel du réseau, une stratégie employée en vigueur consiste à déposer un réseau de microlentilles sur le réseau de photodiodes. Chaque microlentille permet la concentration du rayonnement incident au centre de chaque pixel dans un point focal coïncidant avec une région de photodétecteurs multiples. Cette solution est difficile à implémenter car elle nécessite des étapes de fabrication sur la face arrière du réseau pour former des microstructures en 3D. De plus, la FTM peut être limitée par la diffraction du rayonnement incident au niveau de l'interface entre deux microlentilles, ainsi que par la diffusion latérale des porteurs de charges dans le cas d'un réseau de photodiodes planaire.

La présente invention a pour objectif de résoudre au moins en partie les problèmes mentionnés ci-dessus en proposant une architecture de réseau dans lequel les photodiodes sont espacées l'une des autres, et dans lequel la forme géométrique de la région active de chaque photodiode permet une meilleure concentration du rayonnement au centre du pixel.

### RESUME

Pour atteindre l'objectif mentionné ci-dessus, selon un mode de réalisation on prévoit un réseau d'au moins deux photodiodes dans lequel chaque photodiode comprend une région d'absorption et une région de captation, la région de captation comprenant un plot électriquement conducteur, la région d'absorption étant en contact avec la région de captation, la région d'absorption étant configurée pour absorber un rayonnement incident sur la photodiode et pour permettre une diffusion de porteurs de charge, et dans lequel chaque région d'absorption est séparée des autres régions d'absorption, caractérisé en ce que la région d'absorption de chaque photodiode présente une forme convexe vers le rayonnement incident.

Chaque photodiode du réseau comprend en outre suivant un aspect non limitatif une région de recouvrement à base d'un premier semiconducteur, la région de recouvrement recouvrant une face supérieure de la région d'absorption en regard du rayonnement incident.

Un des avantages de cette architecture est la séparation physique des régions d'absorption. Cela a pour effet d'isoler électriquement la photodiode et de réduire la diaphonie dans le réseau.

Un deuxième avantage est la forme convexe de la région d'absorption, qui permet d'optimiser la concentration du rayonnement au centre de chaque photodiode, ce qui améliore le rendement quantique, réduit le volume du courant d'obscurité, augmente la température de fonctionnement ainsi que la FTM du réseau.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La figure 1 représente une vue de dessus d'un réseau imageur comprenant plusieurs photodiodes.
La figure 2 représente une vue en coupe d'un réseau comprenant au moins deux photodiodes.
Les figures 3A et 3B représentent deux modes de réalisation du réseau de photodiodes selon l'invention. La figure 3A représente un premier mode de réalisation, dans lequel la région d'absorption et la région de recouvrement d'une part et la région de collecte d'autre part présentent des types de dopage distincts.
La figure 3B représente un deuxième mode de réalisation du réseau selon l'invention, dans lequel la région d'absorption et la région de collecte d'une part et la région de recouvrement d'autre part présentent des types de dopage distincts.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les dimensions ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un mode de réalisation avantageux, chaque photodiode 100a, 100b, du réseau 1 comprend une région d'absorption 20 et une région de captation 70. La région de captation 70 comprend un plot 50 électriquement conducteur, et la région d'absorption 20 est en contact avec la région de captation 70. La région d'absorption 20 est configurée pour absorber un rayonnement incident sur la photodiode et pour permettre une diffusion de porteurs de charge. Chaque région d'absorption 20 est séparée des autres régions d'absorption 20. La région d'absorption 20 de chaque photodiode 100a, 100b, présente une forme convexe vers le rayonnement incident. Cela permet d'augmenter la distance parcourue par le rayonnement à l'intérieur de la région d'absorption 20, et en conséquence, d'améliorer l'absorption du rayonnement et le rendement quantique du réseau.

Selon un mode de réalisation avantageux, chaque photodiode 100a, 100b, comprend en outre une région de recouvrement 10 à base d'un premier semiconducteur. La région de recouvrement 10 recouvre une face supérieure 20a de la région d'absorption 20 en regard du rayonnement incident.

Avantageusement, la région de recouvrement 10 présente une première énergie de bande interdite E₁₀ supérieure à 0,41 eV. Cela favorise la transparence de la couche de recouvrement 10 aux longueurs d'onde supérieures à 3 µm.

Selon un exemple préférentiel, la face supérieure 10a de la région de recouvrement 10 en regard du rayonnement incident, présente une surface convexe vers le rayonnement incident.

Préférentiellement, la région d'absorption 20 de chaque photodiode 100a, 100b, présente une forme convexe curviligne, de préférence une forme d'arc de cercle, de préférence une demi-sphère. Selon un autre exemple, la région d'absorption 20 de chaque photodiode 100a, 100b présente une forme conique ou tronconique. Selon un autre exemple, la région d'absorption 20 de chaque photodiode 100a, 100b présente une forme de tronc de pyramide.

Avantageusement, la région d'absorption 20 présente une deuxième énergie de bande interdite E₂₀, avec E₁₀>E₂₀. La valeur élevée de l'énergie de bande interdite E₁₀ permet la réduction de l'influence des défauts présents sur la face supérieure 20a de la photodiode.

De préférence, la région de captation 70 comprend en outre une région de collection 30 située entre la région d'absorption 20 et le plot 50 électriquement conducteur. La région de collection 30 est à base d'un troisième semiconducteur. La région de collection 30 est en contact avec la région d'absorption 20 et avec le plot 50 électriquement conducteur.

De préférence, chaque photodiode 100a, 100b, comprend une couche de passivation 40 en contact avec une face inférieure 20b de la région d'absorption 20 opposée à une face supérieure 20a de la région d'absorption 20 en regard du rayonnement incident. La couche de passivation 40 présente des ouvertures 45a, 45b, chaque ouverture 45a, 45b, étant en regard de la région d'absorption 20 d'une photodiode 100a, 100b, distincte. La région de captation 70 de ladite photodiode 100a, 100b, s'étend dans ladite ouverture 45a, 45b.

Selon un exemple, la région d'absorption 20 contient une zone d'ouverture de gap 60 s'étendant depuis une face inférieure 20b de la région d'absorption 20 opposée à une face supérieure 20a de la région d'absorption 20 en regard du rayonnement incident. La zone d'ouverture de gap 60 présente une variation de son énergie de bande interdite selon une direction, dite direction normale, sensiblement perpendiculaire à la face inférieure 20b de la région d'absorption 20.

Selon un exemple, la région d'absorption 20 présente une hauteur maximale h₂₀ selon la direction normale et la zone d'ouverture de gap 60 présente une hauteur maximale h₆₀ selon la direction normale, avec h₆₀≤0,5*h₂₀, de préférence h₆₀≤0,3*h₂₀, de préférence h₆₀≤0.1*h_{20.}

Selon un exemple, la zone d'ouverture de gap 60 présente une hauteur minimale h₆₀ selon la direction normale, avec de préférence h₆₀≥100 nm.

Selon un mode de réalisation, la région de recouvrement 10 et la région d'absorption 20 sont dopées, la région de recouvrement 10 présente le même type de dopage que celui de la région d'absorption 20, et en outre, la région de collection 30 présente un type de dopage opposé à celui de la région d'absorption 20.

Selon un mode de réalisation, la région de recouvrement 10 et la région d'absorption 20 sont dopées, la région de recouvrement 10 présente un type de dopage opposé à celui de la région d'absorption 20, et en outre, la région de collection 30 et la région d'absorption 20 présentent le même type de dopage.

Selon un exemple, les régions de recouvrement 10 d'au moins deux des photodiodes 100a, 100b, forment une couche continue.

Selon un exemple préféré, la région d'absorption 20 présente un niveau de dopage inférieur à 10¹⁶ cm⁻³, de préférence inférieur à 2*10¹⁵ cm⁻³, de préférence inférieur à 2*10¹⁴ cm⁻³. Cela permet le fonctionnement de la photodiode comme une photodiode PIN déplétée à haute température de fonctionnement.

Selon un autre exemple préféré, la région de recouvrement 10 présente un niveau de dopage supérieur à 10¹⁶ cm⁻³, de préférence supérieur à 10¹⁷ cm⁻³. Cela donne lieu à une ouverture de gap effectif par effet Moss-Burstein pour un dopage de type N dans la région de recouvrement 10.

De préférence, la région de collection 30 présente un niveau de dopage supérieur à 10¹⁶ cm⁻³.

Selon un exemple préféré, la région d'absorption 20 présente une deuxième énergie de bande interdite E₂₀ comprise entre 0,23 et 0,3 eV.

Selon un exemple, la région d'absorption 20 est à base d'un deuxième semiconducteur, le premier semiconducteur, le deuxième semiconducteur et le troisième semiconducteur sont les mêmes, et sont par exemple à base de CdHgTe. L'énergie de la bande interdite est ainsi contrôlée en variant le pourcentage de cadmium (Cd) dans la composition de CdHgTe.

Selon un exemple préféré, la région d'absorption 20 présente un dopage de type N.

Selon un exemple, la région d'absorption 20 est à base de CdHgTe. Selon un exemple, la région de recouvrement 10 est à base de CdHgTe. Selon un exemple, la région de collection 30 est à base de CdHgTe. La région d'absorption 20, la région de recouvrement 10 et la région de collection 30 peuvent toutes les trois être à base du matériau, sans pour autant que ce matériau se présente sous la même composition dans les trois régions. Les pourcentages de chacun des éléments constituant le matériau peuvent varier d'une région à l'autre. Par exemple, lorsque la région d'absorption 20, la région de recouvrement 10 et la région de collection 30 sont toutes les trois à base de CdHgTe, la proportion de cadmium peut varier d'une région à l'autre.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt, le report, le collage, l'assemblage ou l'application d'une première couche sur une deuxième couche, ne signifie pas obligatoirement que les deux couches sont directement au contact l'une de l'autre, mais signifie que la première couche recouvre au moins partiellement la deuxième couche en étant, soit directement à son contact, soit en étant séparée d'elle par au moins une autre couche ou au moins un autre élément.

Une couche peut par ailleurs être composée de plusieurs sous-couches d'un même matériau ou de matériaux différents.

On entend par un substrat, une couche, un dispositif, « à base » d'un matériau M, un substrat, une couche, un dispositif comprenant ce matériau M uniquement ou ce matériau M et éventuellement d'autres matériaux, par exemple des éléments d'alliage, des impuretés ou des éléments dopants. Ainsi un matériau à base d'un matériau III-V peut comprendre un matériau III-V additionné de dopants.

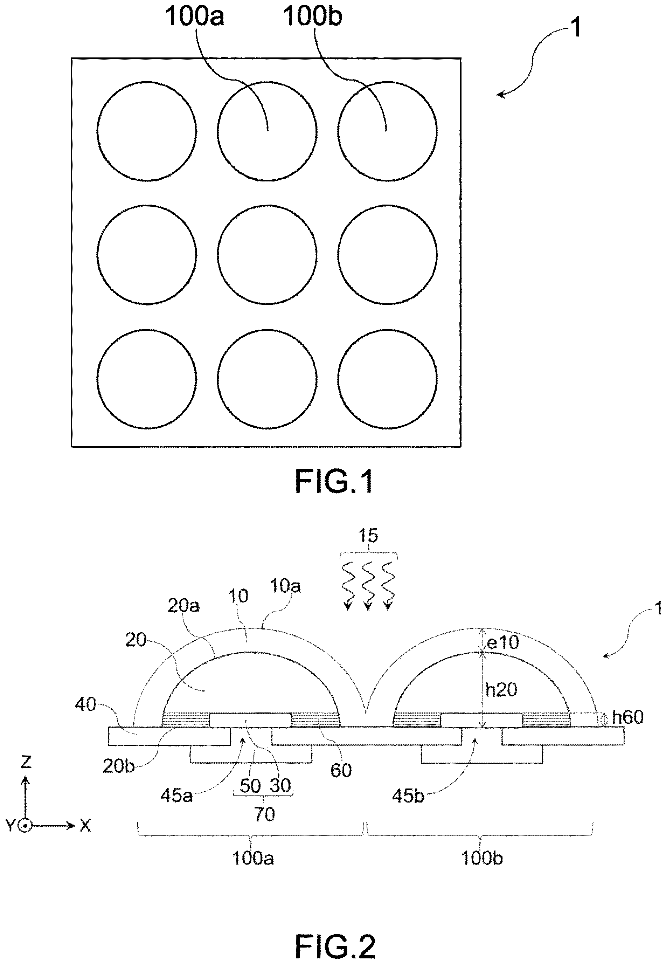

Un repère, de préférence orthonormé, comprenant les axes X, Y, Z est représenté en figure 2. Ce repère est applicable par extension aux autres figures.

Dans la présente demande de brevet, on parlera préférentiellement d'épaisseur pour une couche et de hauteur pour une structure ou un dispositif. La hauteur est prise perpendiculairement au plan horizontal XY. L'épaisseur est prise selon une direction normale au plan d'extension principal de la couche. Ainsi, une couche présente typiquement une épaisseur selon Z, lorsqu'elle s'étend principalement le long du plan horizontal XY, et un élément en saillie, par exemple une tranchée d'isolation, présente une hauteur selon Z. Les termes relatifs « sur », « sous », « sous-jacent » se réfèrent préférentiellement à des positions prises selon la direction Z.

Les termes « sensiblement », « environ », « de l'ordre de » signifient « à 10% près, de préférence à 5% près ».

L'invention porte sur un réseau 1 de photodiodes 100a, 100b étant par exemple disposées sur un substrat semiconducteur, tel qu'illustré en vue de dessus à la figure 1. Le réseau 1 comporte au moins deux photodiodes 100a et 100b. Le réseau 1 peut également être décrit comme un réseau de pixels. Chacune des photodiodes 100a, 100b fait avantageusement partie d'un pixel. Un pixel peut comprendre une unique photodiode 100a, 100b ou bien une pluralité de photodiodes 100a, 100b.

Lors de l'utilisation du réseau 1, ce dernier est exposé à un rayonnement incident 15. Ce rayonnement incident présente de préférence une composante non nulle selon la direction Z.

Selon un mode de réalisation, chaque photodiode 100a, 100b comprend les éléments illustrés à la figure 2, qui seront détaillés dans ce qui suit.

Chaque photodiode 100a, 100b comprend une région d'absorption 20 à base d'un matériau semi-conducteur. Cette région d'absorption 20 permet l'absorption du rayonnement incident 15 à la photodiode 100a, 100b et la génération de paires électron-trou. Les porteurs de charges sont ensuite diffusés à travers la région d'absorption 20 vers une zone de captation 70.

Les régions d'absorption 20 de photodiodes 100a, 100b distinctes sont séparées ou espacées physiquement les unes des autres. Dit autrement, il n'y a pas de contact entre les régions d'absorption 20 du réseau 1. Cela permet de garantir un confinement des porteurs de charge photo-générés dans chacune des régions d'absorption 20, et, en conséquence, de garantir un bon niveau de la FTM.

Dans le but d'améliorer la sensibilité de la photodiode 100a, 100b au rayonnement incident, la forme géométrique de la région d'absorption 20 est optimisée afin de concentrer le rayonnement incident au centre de la photodiode 100a, 100b.

Selon l'invention, la région d'absorption 20 de chaque photodiode 100a, 100b présente une forme convexe vers le rayonnement incident 15. La forme géométrique convexe de la région d'absorption 20 peut adopter l'une des configurations suivantes : une forme dont la face supérieure en regard du rayonnement incident 15 est convexe curviligne, de préférence en forme d'arc de cercle, de préférence une demi-sphère, un cône tronqué, une pyramide tronquée, ou toute forme géométrique E tridimensionnelle, telle que tout segment ayant ses extrémités dans E est entièrement inclus dans E, et dont la face supérieure en regard du rayonnement incident permet la concentration du rayonnement au centre de la face inférieure de E, opposée à la face supérieure de E. La forme convexe est de manière avantageuse configurée pour dévier la direction de propagation du rayonnement se propageant dans la photodiode de la direction du rayonnement incident. La convexité de la région d'absorption 20 est donnée par la forme de sa face supérieure 20a. La région d'absorption 20 présente également une face inférieure 20b en regard de la face supérieure 20a.

La forme convexe de la région 20 permet la réfraction du rayonnement incident vers le centre de la photodiode 100a, 100b, ce qui permet d'augmenter la distance parcourue par le rayonnement à l'intérieur de la région d'absorption 20, et en conséquence, d'améliorer l'absorption du rayonnement et le rendement quantique du réseau 1. Il est important de noter que la réfraction du rayonnement est plus importante lorsque le rayonnement est incident sur les flancs de la face supérieure 20a de la région d'absorption 20, occupant une partie principale de la surface de la photodiode.

La région d'absorption 20 est fabriquée à base d'un matériau semi-conducteur, de préférence l'un parmi les matériaux suivants : un semiconducteur II-VI tel que le CdHgTe (ou HgCdTe), un semiconducteur III-V, par exemple un matériau massif comme l'InAsSb, ou encore un matériau à structure de bande d'énergie effective, pouvant par exemple être obtenu dans le cas de super réseaux de type II.

La région d'absorption 20 est avantageusement dopée, de préférence avec un dopage de type N. Elle présente par ailleurs une énergie de bande interdite E₂₀. Ladite énergie est adaptée afin de favoriser la détection du rayonnement dans une bande spectrale donnée, de préférence dans le moyen infrarouge. La valeur de E₂₀ est de préférence comprise entre 0,23 eV et 0,3 eV à une température de fonctionnement donnée.

Le niveau de dopage de la région d'absorption 20 est avantageusement inférieur à 10¹⁶ cm⁻³, de préférence inférieur à 2*10¹⁵ cm⁻³, de préférence inférieur à 2*10¹⁴ cm⁻³. Le faible dopage de la région d'absorption 20 permet le fonctionnement de la photodiode comme une photodiode PIN déplétée à haute température de fonctionnement. La réduction voire la suppression des porteurs libres au sein de la région d'absorption 20 permet de réduire voire supprimer la génération Auger du courant d'obscurité et d'obtenir une très haute température de fonctionnement. Dans ce cas, la séparation électrique des régions d'absorption 20 des différentes photodiodes supprime la modulation du champ en fonction du courant détecté lorsque les photodiodes sont hybridées avec un circuit CMOS fonctionnant en injection directe. Ainsi, le fonctionnement d'un réseau 1 de photodiodes dont les régions d'absorption 20 sont déplétées selon ce mode de réalisation est plus stable que celui attendu pour une matrice réalisée selon l'état de l'art.

Afin d'extraire les porteurs de charge vers un circuit de multiplexage souvent réalisé en technologie CMOS (ou « complementary metal oxide semi-conductor » en anglais) en silicium, chaque photodiode 100a, 100b comprend en outre une région de captation 70 en contact avec la région d'absorption 20, comme illustré en figure 2. La région de captation 70 comprend un plot 50 électriquement conducteur typiquement relié à un noeud d'entrée du circuit CMOS.

La région de captation 70 peut en outre comprendre une région de collection 30 située entre la région d'absorption 20 et le plot 50 électriquement conducteur. La région de collection 30 est à base d'un matériau semiconducteur, de préférence le même matériau que celui constituant la région d'absorption 20, comme le CdHgTe par exemple. Dans le cas où la région de collection 30 et la région d'absorption 20 sont à base du même matériau semiconducteur, il est possible que la composition de ce matériau semiconducteur soit distincte d'une région 30 à l'autre 20. Par exemple, le cadmium présent dans le CdHgTe constituant la région de collection 30 peut se trouver dans un pourcentage différent que dans la région d'absorption 20. La région de collection 30 est en contact avec la région d'absorption 20 et avec le plot 50 électriquement conducteur, et assure de préférence le transfert des porteurs de charges depuis la région d'absorption 20 vers le plot 50.

La région de collection 30 présente avantageusement un niveau de dopage supérieur à 10¹⁶ cm⁻³. Cela permet d'obtenir un bon contact ohmique avec le plot 50 et de limiter l'extension de la zone de charge d'espace dans la région 30. La région de collection 30 peut présenter un type de dopage opposé à celui de la région d'absorption 20, selon un premier mode de réalisation, ou le même type de dopage que celui de la région d'absorption 20, selon un deuxième mode de réalisation. Ces deux modes de réalisation particuliers seront décrits en détail plus avant.

Chaque photodiode 100a, 100b, comprend de préférence une couche de passivation 40 qui assure sa protection électrique, mécanique et chimique. La couche de passivation 40 est de préférence à base d'un matériau du même groupe de semi-conducteurs que les matériaux formant la région de recouvrement 10, la région d'absorption 20 et la région de collection 30. Lorsque la région de recouvrement 10, la région d'absorption 20 et la région de collection 30 sont à base d'un matériau II-VI, par exemple le CdHgTe, la couche de passivation 40 est réalisée à base d'un autre matériau semiconducteur II-VI tel que le ZnS. La couche de passivation 40 est en contact avec une partie de la face inférieure 20b de chaque photodiode 100a, 100b. Elle présente des ouvertures 45a, 45b, chaque ouverture 45a, 45b étant en regard de la région d'absorption 20 d'une photodiode 100a, 100b distincte. La région de captation 70 s'étend dans les ouvertures 45a, 45b de la couche de passivation 40 pour assurer un contact électrique avec la région d'absorption 20.

Chaque photodiode 100a, 100b, comprend en outre de préférence une région de recouvrement 10 à base d'un matériau semiconducteur, de préférence le même matériau que celui constituant la région d'absorption 20 comme le CdHgTe par exemple. Dans le cas où la région de recouvrement 10 et la région d'absorption 20 sont à base du même matériau semiconducteur, il est possible que la composition de ce matériau semiconducteur soit distincte d'une région 10 à l'autre 20. Par exemple, le cadmium présent dans le CdHgTe constituant la région de recouvrement 10 peut se trouver dans un pourcentage différent que dans la région d'absorption 20. La région de recouvrement 10 recouvre la face supérieure 20a de la région d'absorption 20 en regard du rayonnement incident, de préférence dans son intégralité. La région de recouvrement 10 peut recouvrir toute la surface du réseau 1 d'une manière continue, de sorte qu'elle soit jointive entre les photodiodes 100a et 100b, ou elle peut recouvrir chaque photodiode distincte 100a, 100b d'une manière non jointive. La région de recouvrement 10 possède une épaisseur de préférence constante ou conforme. Cette épaisseur est typiquement comprise entre 0,1*h₂₀ et 0,25*h₂₀. Avantageusement, la région de recouvrement 10 sépare les photodiodes 100a, 100b les unes des autres dans le plan XY. Ainsi, la région de recouvrement 10 permet d'empêcher la diffusion entre les photodiodes 100a et 100b du réseau 1, des porteurs minoritaires générés dans la région d'absorption 20. Cela est en faveur d'une augmentation de la FTM de chaque photodiode 100a, 100b.

La face supérieure 10a de la région de recouvrement 10 en regard du rayonnement incident 15 présente de préférence une forme convexe vers le rayonnement incident. Ladite face supérieure 10a de la région de recouvrement 10 peut adopter une forme convexe curviligne, de préférence en forme d'arc de cercle, de préférence une forme de surface de demi-sphère, une forme de surface de cône tronqué, ou encore une forme de surface d'une pyramide tronquée. Quelle que soit la forme géométrique de la face supérieure 10a de la région de recouvrement 10, elle peut couvrir les photodiodes 100a, 100b, du réseau 1 soit d'une manière continue jointive entre les photodiodes 100a et 100b, soit d'une manière non jointive entre les différentes photodiodes. Par ailleurs, on prévoit avantageusement que la face supérieure 10a de la région de recouvrement 10 et la face supérieure 20a de la région d'absorption 20 présentent des géométries du même type. Par exemple, selon un mode de réalisation avantageux, la face supérieure 10a de la région de recouvrement 10 et la face supérieure 20a de la région d'absorption 20 présentent toutes les deux une forme d'arc de cercle, de préférence concentriques.

La région de recouvrement 10 possède une énergie de bande interdite E₁₀ avec E₁₀>E₂₀. De préférence, ladite énergie de bande interdite E₁₀ de la couche de recouvrement 10 est supérieure à 0,41 eV. Cela favorise la transparence de la couche de recouvrement 10 aux longueurs d'onde supérieures à 3 µm. La valeur élevée de l'énergie de bande interdite E₁₀ permet en outre la réduction de l'influence des défauts présents sur la face supérieure 10a de la photodiode qui peuvent induire un excès de courant d'obscurité et de bruit. Elle permet également de réduire l'absorption du rayonnement incident 15 dans la région de recouvrement 10.

La région de recouvrement 10 peut avoir le même type de dopage que celui de la région d'absorption 20, selon un premier mode de réalisation, ou un type de dopage opposé à celui de la région d'absorption 20 selon un deuxième mode de réalisation. De préférence, la région de recouvrement 10 présente un niveau de dopage supérieur à 10¹⁶ cm⁻³, de préférence supérieur à 10¹⁷ cm⁻³.

Le niveau de dopage élevé de la région de recouvrement 10 donne lieu à une ouverture de gap effectif par effet Moss-Burstein dans le cas où la région de recouvrement 10 et la région d'absorption 20 présentent un dopage de type N. Cette ouverture de gap induit une courbure de la bande de valence dans la région de recouvrement 10. Cela a pour effet la limitation de l'interaction entre les porteurs de charge minoritaires et les défauts présents sur la face supérieure 10a de la photodiode, en faveur d'une réduction de courant d'obscurité et une augmentation du rendement quantique de chaque photodiode.

Au sein d'une photodiode 100a, 100b, la région de recouvrement 10 et la région de collection 30 admettent de préférence toutes les deux une symétrie de rotation autour d'un même axe (parallèle à l'axe Z sur les figures). Associée à la réduction du nombre de porteurs libres au sein de la région d'absorption 20, la configuration symétrique de la région de recouvrement 10 autour de la région de collection 30 permet une déplétion très importante voire complète de la région d'absorption 20, avec très peu de voire sans poche non-déplétée. Cela permet de limiter le courant d'obscurité.

Selon une variante de réalisation de l'invention, la région d'absorption 20 contient une zone d'ouverture de gap 60 qui s'étend depuis la face inférieure 20b de la région d'absorption 20, comme illustré dans la figure 2. La zone d'ouverture de gap 60 présente une variation de son énergie de bande interdite selon une direction, dite direction normale, sensiblement perpendiculaire à la face inférieure 20b de la région d'absorption 20. La direction normale correspond à la direction Z sur les figures. La zone d'ouverture de gap 60 s'étend de préférence tout autour de la région de collection 30 en projection dans le plan XY.

La région d'absorption 20 présente une hauteur maximale h₂₀ typiquement mesurée selon la direction normale. Dans le cas où la région d'absorption 20 présente la forme d'une calotte sphérique, la hauteur maximale h₂₀ correspond typiquement à la hauteur de la calotte sphérique. Dans le cas où la région d'absorption 20 présente une forme tronconique ou pyramidale, la hauteur maximale h₂₀ correspond typiquement à la hauteur mesurée entre sa petite base et sa grande base. La zone d'ouverture de gap 60 présente une hauteur maximale h₆₀ selon la direction normale. Avantageusement, h₆₀≤0,5*h₂₀, de préférence h₆₀≤0,3*h₂₀, de préférence h_{60≤}0.1*h₂₀. La hauteur h₆₀ de la zone d'ouverture de gap 60 est de préférence supérieure ou égale à 100 nm.

Selon une variante de réalisation de l'invention, la face supérieure 10a de la région de recouvrement 10 est couverte d'une couche transparente au rayonnement incident aux photodiodes 100a, 100b du réseau 1. Cette couche a pour objectif d'améliorer la transmission du rayonnement incident vers la région d'absorption 20, grâce à son indice de réfraction choisi minutieusement selon l'application.

Selon une variante de réalisation de l'invention, une région électriquement conductrice disposée à l'extérieur du réseau 1 de photodiodes, permet d'établir un contact ohmique avec la région de recouvrement 10.

En variant le type de dopage des régions d'absorption 20, de recouvrement 10 et de collection 30, deux modes de réalisation principaux de l'invention sont éventuellement envisageables.

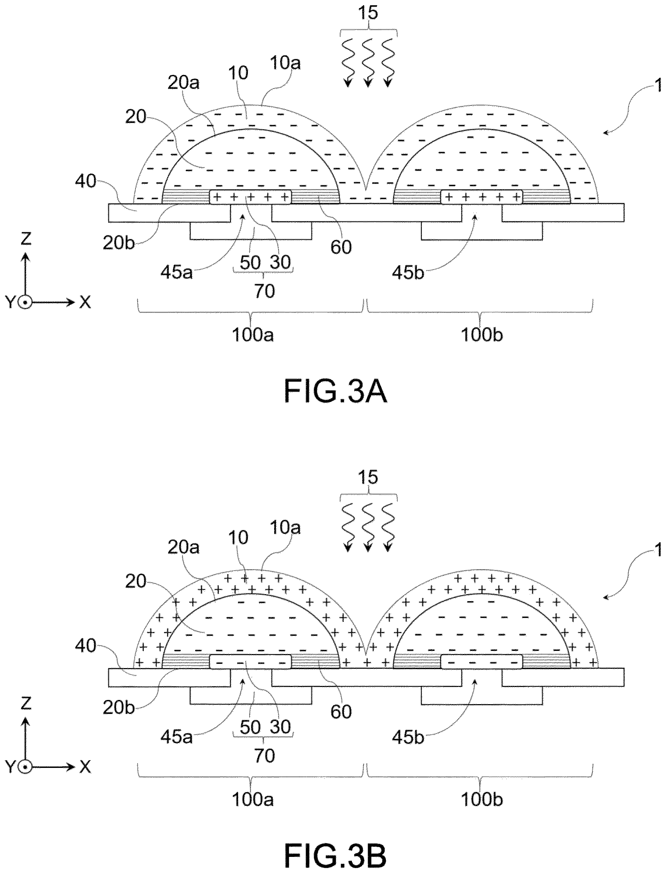

Selon le premier de ces deux modes de réalisation, comme illustré à la figure 3A, la région de recouvrement 10 présente le même type de dopage que celui de la région d'absorption 20, de préférence de type N. En outre, la région de collection 30 présente un type de dopage opposé à celui de la région d'absorption 20, de préférence de type P, formant ainsi une jonction p-n avec la région d'absorption 20 dans chaque photodiode 100a, 100b du réseau 1. La jonction p-n ainsi formée induit la séparation des charges photo-générées dans la région d'absorption 20 et leur extraction vers le plot 50. Dans le cas d'un dopage de type N dans la région de recouvrement 10 et la région d'absorption 20, une ouverture de gap effectif est possible. Cette ouverture de gap effectif et la séparation des régions d'absorption de chaque photodiode 100a, 100b, impliquent que les porteurs de charge séparés par chaque jonction p-n d'une photodiode individuelle sont donc ceux générés dans la région d'absorption 20 de la même photodiode. Par conséquent, la FTM d'un réseau 1 réalisé selon ce premier mode est améliorée.

Selon le deuxième de ces deux modes de réalisation, comme illustré à la figure 3B, la région de recouvrement 10 présente un type de dopage opposé à celui de la région d'absorption 20, de préférence de type P, formant ainsi une jonction p-n avec la région d'absorption 20 dans chaque diode du réseau 1. La jonction p-n permet ainsi de collecter d'une façon individuelle les trous générés dans la région d'absorption 20. Les régions d'absorption de chaque photodiode 100a, 100b étant non-jointives, les porteurs de charge séparés par chaque jonction p-n d'une photodiode individuelle sont donc ceux générés dans la région d'absorption 20 de la même photodiode. De ce fait, la FTM d'un réseau 1 réalisé selon ce deuxième mode est améliorée. En outre, la région de collection 30 présente le même type de dopage que celui de la région d'absorption 20, de préférence de type N. Cela favorise un bon contact ohmique avec le plot 50.

Exemple de procédé de fabrication permettant d'obtenir un réseau selon l'invention Le réseau 1 selon l'invention, comprenant tous les éléments détaillés ci-dessus, peut être réalisé selon un procédé comprenant les étapes successives suivantes :
1. Une couche épitaxiée, de préférence à base d'un matériau CdHgTe, est d'abord fabriquée sur un substrat, de préférence à base d'un matériau CdZnTe, par croissance en phase liquide ou par jet moléculaire.
2. Une espèce dopante est implantée localement au niveau d'une pluralité de zones de la couche épitaxiée. Ces zones formeront les régions de collection 30 de chaque photodiode 100a, 100b du réseau 1, voire de plusieurs réseaux 1. L'espèce dopante est de préférence un dopant de type accepteur, de préférence pris parmi l'élément As et l'élément Sb.
3. Une couche de passivation 40 est ensuite déposée sur la couche épitaxiée.
4. L'ensemble est ensuite recuit, de préférence sous pression de Hg, afin d'activer le dopant localisé, formant ainsi les régions de collection 30. Le recuit permet en outre de combler de potentielles lacunes par des ions Hg et d'obtenir un dopage de type N dans la couche épitaxiée afin de former les régions d'absorption 20. Ce recuit va aussi permettre de former les zones d'ouverture de gap 60 par interdiffusion avec la couche de passivation 40 qui, de préférence, est réalisée à base du même matériau semiconducteur que celui des régions d'absorption 20.
5. Les ouvertures 45a, 45b dans la couche de passivation 40 sont ensuite gravées localement, chaque ouverture 45a, 45b étant en regard d'une région de collection 30 distincte.
6. Les plots 50 à base d'un matériau électriquement conducteur sont ensuite déposés localement au niveau de chaque photodiode 100a, 100b de chaque réseau 1, dans les ouvertures 45a, 45b de la couche de passivation 40 et de préférence également au contact de la face inférieure 40b de la couche de passivation 40.
7. Une gravure dans le substrat est réalisée à la périphérie de chaque réseau 1 de détection afin de former une ouverture associée à chaque réseau 1 de détection. Une couche métallique continue est ensuite formée localement sur les plots 50 de chaque réseau de photodiodes ainsi que dans l'ouverture associée au réseau considéré, formant ainsi à travers un contact collectif à toutes les photodiodes 100a, 100b de chaque réseau 1.
8. Les réseaux 1 fabriqués sur le même wafer sont ensuite découpés, pour obtenir un ensemble de réseaux 1 de préférence identiques. Les étapes suivantes sont donc réalisées indépendamment sur chaque réseau, faisant référence au réseau 1 de la présente invention.
9. Le réseau 1 est ensuite hybridé sur un circuit de lecture, réalisé en technologie Si-CMOS.
10. Le substrat sur lequel la couche épitaxiée a été formée est ensuite éliminé par polissage, ou par gravure chimique, ou une combinaison des deux.
11. Les régions d'absorption 20 du réseau 1 sont ensuite structurées en forme convexe. La structuration est réalisée de préférence par le transfert d'une lithographie en niveaux de gris (ou « à nuances de gris » ou « à échelle de gris ») qui forme une structure complexe dans une couche de résine. La structure convexe est ensuite transférée dans la région d'absorption 20 par une gravure sèche, de préférence une gravure ionique.
12. Les propriétés électriques d'une partie superficielle de la région d'absorption 20 sont ensuite modifiées par un niveau de dopage élevé pour former la région de recouvrement 10. Ce dopage est de préférence de type N, ce qui induit une ouverture gap effectif par l'effet Moss-Burstein. La modification du dopage et de la bande interdite de la région de recouvrement 10 peut être obtenu par implantation ionique d'un élément agissant comme donneur dans le semi-conducteur, tel que l'élément B.

Ce procédé peut être mis en oeuvre pour fabriquer un unique réseau ou bien plusieurs réseaux distincts sur le substrat. Ces étapes peuvent en effet être réalisées simultanément pour former plusieurs photodiodes mais également plusieurs réseaux.

L'invention n'est pas limitée aux modes de réalisations précédemment décrits et s'étend à tous les modes de réalisation couverts par l'invention.

## Revendications

1. Réseau (1) d'au moins deux photodiodes (100a, 100b) dans lequel chaque photodiode comprend une région d'absorption (20) et une région de captation (70), la région de captation (70) comprenant un plot (50) électriquement conducteur, la région d'absorption (20) étant en contact avec la région de captation (70), la région d'absorption (20) étant configurée pour absorber un rayonnement incident sur la photodiode et pour permettre une diffusion de porteurs de charge, et dans lequel chaque région d'absorption (20) est séparée des autres régions d'absorption (20), **caractérisé en ce que** la région d'absorption (20) de chaque photodiode (100a, 100b) présente une forme convexe vers le rayonnement incident.

2. Réseau (1) selon la revendication précédente dans lequel chaque photodiode (100a, 100b) comprend en outre une région de recouvrement (10) à base d'un premier semiconducteur, la région de recouvrement (10) recouvrant une face supérieure (20a) de la région d'absorption (20) en regard du rayonnement incident, la région de recouvrement (10) présentant une première énergie de bande interdite E₁₀.

3. Réseau (1) selon la revendication précédente dans lequel la première énergie de bande interdite E₁₀ est supérieure à 0,41 eV.

4. Réseau (1) selon l'une quelconque des deux revendications précédentes dans lequel la région d'absorption (20) présente une deuxième énergie de bande interdite E₂₀, avec E₁₀>E₂₀.

5. Réseau (1) selon l'une quelconque des trois revendications précédentes dans lequel la face supérieure (10a) de la région de recouvrement (10) en regard du rayonnement incident, présente une surface convexe vers le rayonnement incident.

6. Réseau (1) selon l'une quelconque des revendications précédentes dans lequel la région d'absorption (20) de chaque photodiode (100a, 100b) présente une forme convexe curviligne.

7. Réseau (1) selon l'une quelconque des revendications précédentes, dans lequel la région de captation (70) comprend en outre une région de collection (30) située entre la région d'absorption (20) et le plot (50) électriquement conducteur, la région de collection (30) étant à base d'un troisième semiconducteur, la région de collection (30) étant en contact avec la région d'absorption (20) et avec le plot (50) électriquement conducteur.

8. Réseau (1) selon l'une quelconque des revendications précédentes, comprenant une couche de passivation (40) en contact avec une face inférieure (20b) de la région d'absorption (20) opposée à une face supérieure (20a) de la région d'absorption (20) en regard du rayonnement incident, la couche de passivation (40) présentant des ouvertures (45a, 45b), chaque ouverture (45a, 45b) étant en regard de la région d'absorption (20) d'une photodiode (100a, 100b) distincte, la région de captation (70) de ladite photodiode (100a, 100b) s'étendant dans ladite ouverture (45a, 45b).

9. Réseau (1) selon l'une quelconque des revendications précédentes, dans lequel la région d'absorption (20) contient une zone d'ouverture de gap (60) s'étendant depuis une face inférieure (20b) de la région d'absorption (20) opposée à une face supérieure (20a) de la région d'absorption (20) en regard du rayonnement incident, la zone d'ouverture de gap (60) présentant une variation de son énergie de bande interdite selon une direction, dite direction normale, sensiblement perpendiculaire à la face inférieure (20b) de la région d'absorption (20).

10. Réseau (1) selon l'une quelconque des revendications précédentes en combinaison avec la revendication 2, dans lequel la région de recouvrement (10) et la région d'absorption (20) sont dopées, la région de recouvrement (10) présentant le même type de dopage que celui de la région d'absorption (20).

11. Réseau (1) selon la revendication précédente en combinaison avec la revendication 7, dans lequel la région de collection (30) présente un type de dopage opposé à celui de la région d'absorption (20).

12. Réseau (1) selon l'une quelconque des revendications 1 à 9 en combinaison avec la revendication 2, dans lequel la région de recouvrement (10) et la région d'absorption (20) sont dopées, la région de recouvrement (10) présentant un type de dopage opposé à celui de la région d'absorption (20).

13. Réseau (1) selon la revendication précédente en combinaison avec la revendication 7, dans lequel la région de collection (30) et la région d'absorption (20) présentent le même type de dopage.

14. Réseau (1) selon l'une quelconque des revendications précédentes dans lequel la région d'absorption (20) présente un niveau de dopage inférieur à 10¹⁶ cm⁻³, de préférence inférieur à 2*10¹⁵ cm⁻³, de préférence inférieur à 2*10¹⁴ cm⁻³.

15. Réseau (1) selon l'une quelconque des revendications précédentes en combinaison avec la revendication 2 dans lequel la région de recouvrement (10) présente un niveau de dopage supérieur à 10¹⁶ cm⁻³, de préférence supérieur à 10¹⁷ cm⁻³.
